# EUROPEAN PATENT APPLICATION

(11) **EP 4 293 994 A1**
(43) Date of publication of application: **20.12.2023**
(21) Application number: 22807778.0
(22) Date of filing: 10.05.2022
(51) Int. Cl.: H04M 1/02, H01R 12/79, H01R 12/77, H05K 1/11, H05K 3/34

(54) **PRINTED CIRCUIT BOARD CONNECTOR AND ELECTRONIC DEVICE COMPRISING SAME**

(30) Priority: 10.05.2021 KR 20210060206
(71) Applicant: Samsung Electronics Co., Ltd., Suwon-si, Gyeonggi-do 16677 (KR)
(72) Inventor: SHIM, Jongwan, Suwon-si, Gyeonggi-do 16677 (KR); BAE, Bumhee, Suwon-si, Gyeonggi-do 16677 (KR); KIM, Younho, Suwon-si, Gyeonggi-do 16677 (KR)
(74) Representative: Appleyard Lees IP LLP
(86) International application number: PCT/KR2022/006640
(87) International publication number: WO 2022/240130

(57) **Abstract**

An electronic device is disclosed. The electronic device according to an embodiment may comprise: a first substrate including first conductive pads formed at one surface thereof; a second substrate including second conductive pads and third conductive pads opposite to one surface of the first substrate; and a connector interposed between the first and second substrates to connect the first substrate to the second substrate, wherein: the connector comprises an insulative elastic member disposed at one surface of the first substrate, first connection members passing through the insulative elastic member to electrically connect the first conductive pads to the second conductive pads, and second connection members disposed at the third conductive pads of the second substrate; and each of the second connection members is at least partially inserted into the insulative elastic member so as to be provided with an elastic force from the insulative elastic member. Various other embodiments understood through the specification are also possible.

## Description

### [Technical Field]

Embodiments disclosed in the disclosure relate to a connector of a printed circuit board, and an electronic device including the same.

### [Background Art]

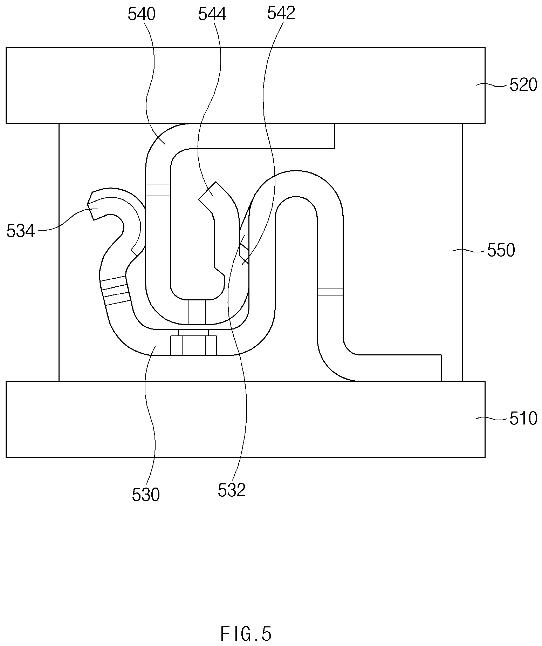

FIG. 5 illustrates a connector structure of a conventional technology.

An electronic device may include printed circuit boards, on which various electronic parts are mounted, and the printed circuit boards may be connected to each other through a connector structure. For example, referring to FIG. 5, a first board 510 and a second board 520 may be connected to each other through a connector structure 550. The connector structure 550 may include a first terminal 530 of a female connector (or a receptacle) (not illustrated) that is disposed in the first board 510, and a second terminal 540 of a male connector (or a plug) (not illustrated) that is disposed in the second board. The first terminal 530 of the female connector and the second terminal 540 of the male connector may be matched and coupled to each other, and thus, the first board 510 and the second board 520 may be electrically and mechanically connected to each other.

### [Disclosure]

### [Technical Problem]

The above-described connector structure 550 may require a structure for maintaining a mechanical coupling state of the first board 510 and the second board 520 while electrically connecting circuit patterns of the first board 510 and the second board 520.

For example, the first terminal 530 and the second terminal 540 of the connector structure 550 may be electrically connected to each other while contacting each other. In addition, the first terminal 530 and the second terminal 540 may extend in complex shapes and may be engaged with each other to provide an elastic force, and stop bosses 532 and 542 for maintaining the coupling state may be formed therein. Accordingly, the first terminal 530 and the second terminal 540 become unnecessarily long, and have stubs 534 and 544 that are irrelevant to electrical connections. Due to the influences of the stubs 534 and 544, discontinuity of impedances may increase or signals may be reflected or resonate whereby transmission characteristics of signals transmitted through the connector structure 550 may be degraded.

Furthermore, the complex shape of the connector structure 550 restricts a change in design or small-sizing thereof and manufacturing costs increase.

The disclosure may provide a connector structure, in which a structure for electrical connection and a mechanical coupling structure are separated.

### [Technical Solution]

An electronic device according to various embodiments may include a first board including first conductive pads formed on one surface thereof, a second board including second conductive pads and third conductive pads facing the one surface of the first board, and a connector interposed between the first board and the second board and connecting the first board and the second board, the connector may include an insulating elastic member disposed on the one surface of the first board, first connection members passing through the insulating elastic member and electrically connecting the first conductive pads and the second conductive pads, and second connection members disposed between the third conductive pads of the second board, and the second connection members may be at least partially inserted into the insulating elastic member to be provided with an elastic force by the insulating elastic member.

A connector interposed between a first board and a second board and configured to connect the first board and the second board according to various embodiment include an insulating elastic member disposed on a first surface of the first board, first conductive elastic members electrically connecting first conductive pads passing through the insulating elastic member and formed on the first surface of the first board, and second conductive pads formed in the second board and facing the first board, and solder balls formed in the second board and bonded to third conductive pads facing the first board, and the solder balls may be at least partially inserted into the insulating elastic member to be provided with an elastic force by the insulating elastic member.

### [ Advantageous Effects]

According to embodiments disclosed in the disclosure, a connector having improved signal transmission characteristics, and an electronic device including the same may be provided.

According to embodiments disclosed in the disclosure, a connector that may reduce design restrictions in disposition and arrangement of pins and may be made small-sized, and an electronic device including the same may be provided.

In addition, various effects directly or indirectly recognized through the disclosure may be provided.

### [ Description of Drawings]

FIG. 1A is a front perspective view of an electronic device according to an embodiment.
FIG. 1B is a rear perspective view of the electronic device according to an embodiment.
FIG. 1C is an exploded perspective view of the electronic device according to an embodiment.
FIG. 2A is a view illustrating a connector structure of an electronic device according to an embodiment.
FIG. 2B is a view illustrating a connector structure of an electronic device according to an embodiment.
FIG. 3 is a view illustrating a connector structure of an electronic device according to an embodiment.
FIG. 4 is a graph depicting S-parameters of a connector structure according to an embodiment and a connector structure according to a comparative example.
FIG. 5 illustrates a connector structure according to a conventional technology.
FIG. 6 is a block diagram of an electronic device in a network environment according to various embodiments.

In relation to a description of drawings, the same or similar components may be denoted by the same or similar reference numerals.

### [ Mode for Invention]

Hereinafter, various embodiments of the disclosure will be described with reference to the accompanying drawings. However, it should be understood that the disclosure is not limited to specific embodiments and includes various modifications, equivalents, and/or alternatives of the embodiments of the disclosure.

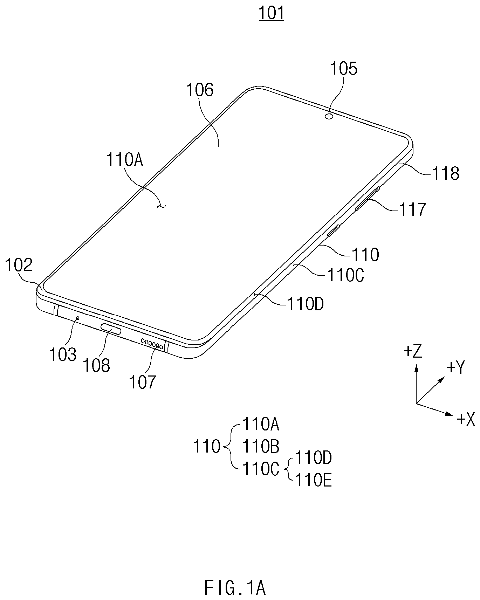

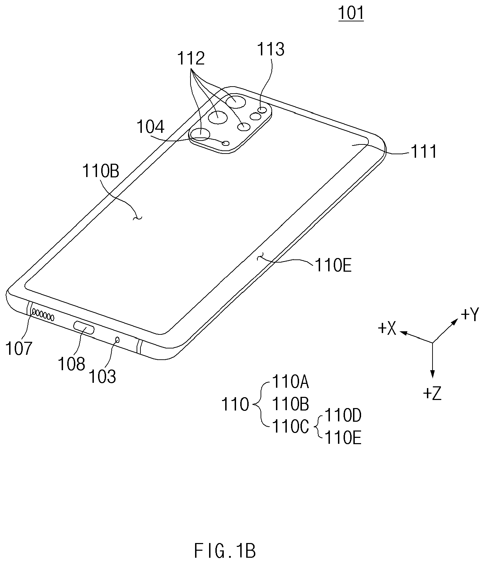

FIG. 1A is a front perspective view of an electronic device according to an embodiment. FIG. 1B is a rear perspective view of the electronic device according to an embodiment. Referring to FIGS. 1A and 1B, an electronic device 101 (e.g., an electronic device 501 of FIG. 5) may include a housing 110 including a first surface (or a front surface) 110A, a second surface (or a rear surface) 110B, and a side surface 110C that surrounds a space between the first surface 110A and the second surface 110B. In another embodiment (not illustrated), the housing 110 may refer to a structure that defines some of the first surface 110A, the second surface 110B, and the side surface 110C.

In an embodiment, at least a portion of the first surface 110A may be formed by a substantially transparent front plate 102 (e.g., a glass plate including various coating layers or a polymer plate). The second surface 110B may be defined by a substantially opaque rear plate 111. The rear plate 111, for example, may be formed of coated or colored glass, ceramics, a polymer, a metal (e.g., aluminum, stainless steel (STS), or magnesium), or a combination of at least two of the materials. The side surface 110C may be defined by a side bezel structure 118 (or a "frame structure") that is coupled to the front plate 102 and the rear plate 111, and includes a metal and/or a polymer. In another embodiment, the rear plate 111 and the side bezel structure 118 may be integrally formed, and may include the same material (e.g., a metallic material, such as aluminum).

In the illustrated embodiment, the front plate 102 may include two first areas 110D that are curved from a partial area of the first surface 110A toward the rear plate 111 and extends seamlessly. The first areas 110D may be located at opposite ends of long edges of the front plate 102.

In the illustrated embodiment, the rear plate 111 may include two second areas 110E that are curved from a partial area of the second surface 110B toward the front plate 102 and extends seamlessly. The second areas 110E may be located at opposite edges of long edges of the rear plate 111. In another embodiment, the front plate 102 (or the rear plate 111) may include only one of the first areas 110D (or the second areas 110E). Furthermore, in another embodiment, the front plate 102 (or the rear plate 111) may not include some of the first areas 110D (or the second areas 110E).

In an embodiment, when viewed from a lateral side of the electronic device 101, the side bezel structure 118 may have a first thickness (or width) in a lateral direction (e.g., a short edge), in which neither the first areas 110D nor the second areas 110E are included, and may have a second thickness that is smaller than the first thickness in a lateral direction (e.g., a long edge), in which the first areas 110D or the second areas 110E are included.

In an embodiment, the electronic device 101 may include at least one of a display 106, audio modules 103 and 107 (e.g., an audio module 570 of FIG. 5), a sensor module (not illustrated) (e.g., a sensor module 576 of FIG. 5), camera modules 105, 112, and 113 (e.g., a camera module 580 of FIG. 5), a key input device 117 (e.g., an input module 550 of FIG. 5), a light emitting element (not illustrated), and a connector hole 108 (e.g., a connection terminal 578 of FIG. 5). In another embodiment, at least one (e.g., the key input device 117 or the light emitting element (not illustrated)) of the components of the electronic device 101 may be omitted, or another component may be additionally included.

In an embodiment, the display 106 may be exposed through a corresponding portion of the front plate 102. For example, at least a portion of the display 106 may be exposed through the front plate 102 including the first surface 110A and the first area 110D of the side surface 110C.

In an embodiment, a corner of the display 106 may have a shape that is substantially the same as an adjacent outer shape of the front plate 102. In another embodiment (not illustrated), to expand the exposed area of the display 106, an interval between an outskirt of the display 106 and an outskirt of the front plate 102 may be substantially the same.

In an embodiment, a surface (or the front plate 102) of the housing 110 may include a screen display area that is formed as the display 106 is visually exposed. For example, the screen display area may include first surface 110A, and the first area 110D of the side surface.

In another embodiment, the screen display areas 110A and 110D may include a sensing area (not illustrated) that is configured to acquire biometric information of the user. Here, an aspect that "the screen display areas 110A and 110D include the sensing area" may mean that at least a portion of the sensing area overlaps the screen display areas 110A and 110D. For example, the sensing area (not illustrated), similarly to another area of the screen display areas 110A and 110D, may mean an area that may display visual information through the display 106 and additionally may acquire biometric information (e.g., a fingerprint) of the user.

In an embodiment, the screen display areas 110A and 110D of the display 106 may include an area, through which the first camera module 105 (e.g., a punch hole camera) may be visually exposed. For example, at least a portion of a periphery of the area, in which the first camera module 105 is exposed, may be surrounded by the screen display areas 110A and 110D. In an embodiment, the first camera module 105 may include a plurality of camera modules (e.g., the camera module 580 of FIG. 5).

In another embodiment (not illustrated), the display 106 may be coupled to or disposed adjacent to a touch detecting circuit, a pressure sensor that may measure an intensity (pressure) of a touch, and/or a digitizer that detects a stylus pen in a magnetic scheme.

In an embodiment, the audio modules 103, 104, and 107 may include the microphone holes 103 and 104 and the speaker hole 107. In an embodiment, the microphone holes 103 and 104 may include the first microphone hole 103 that is formed in a partial area of the side surface 110C, and the microphone hole 104 that is formed in a partial area of the second surface 110B. Microphones for acquiring sounds may be disposed in interiors of the microphone holes 103 and 104. The microphones may include a plurality of microphones to detect directions of sounds. In an embodiment, the second microphone hole 104 formed in a partial area of the second surface 110B may be disposed to be adjacent to the camera modules 105, 112, and 113. For example, the second microphone hole 104 may acquire sounds when the camera modules 105, 112, and 113 are executed or may acquire sounds when another function is executed.

In an embodiment, the speaker hole 107 may include the external speaker hole 107 and a communication receiver hole (not illustrated). The external speaker hole 107 may be formed at a portion of the side surface 110C of the electronic device 101. In another embodiment, the external speaker hole 107 may be implemented as one hole with the microphone hole 103. Although not illustrated, the communication receiver hole (not illustrated) may be formed at another portion of the side surface 110C. For example, the communication receiver hole (not illustrated) may be formed at another portion (e.g., a portion that faces the +Y axis direction) of the side surface 110C, which faces a portion (e.g., a portion that faces the -Y axis direction) of the side surface 110C, at which the external speaker hole 107 is formed.

In an embodiment, the electronic device 101 may include a speaker that is communicated with the speaker hole 107. In another embodiment, the speaker may include a piezo speaker, in which the speaker hole 107 is omitted.

In an embodiment, the sensor module (not illustrated) (e.g., the sensor module 576 of FIG. 5) may generate electrical signals or data values corresponding to an operation state of the interior of the electronic device 101 or an external environment state. For example, the sensor module may include at least one of a proximity sensor, an HRM sensor, a fingerprint sensor, a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illumination intensity sensor.

In an embodiment, the camera modules 105, 112, and 113 may include the first camera module 105 (e.g., a punch hole camera) that is exposed through the first surface 110A of the electronic device 101, the second camera module 112 that is exposed through the second surface 110B, and/or the flash 113.

In an embodiment, the first camera module 105 may be exposed through a portion of the screen display areas 110A and 110D of the display 106. For example, the first camera module 105 may be exposed through a partial area of the screen display areas 110A and 110D, through an opening (not illustrated) that is formed at a portion of the display 106.

In an embodiment, the second camera module 112 may include a plurality of camera modules (e.g., a dual camera, a triple camera, or a quad camera). However, the second camera module 112 is not necessarily limited to including a plurality of camera modules, and may include one camera module.

The first camera module 105 and the second camera module 112 may include one or a plurality of lenses, an image sensor, and/or an image signal processor. The flash 113, for example, may include a light emitting diode or a xenon lamp. In another embodiment, two or more lenses (an infrared camera, a wide angle camera, or a telescopic lens), and image sensors may be disposed on one surface of the electronic device 101.

In an embodiment, the key input devices 117 may be disposed on the side surface 110C (e.g., the first areas 110D and/or the second areas 110E) of the housing 110. In another embodiment, the electronic device 101 may not include some or all of the key input devices 117, and the key input devices that are not included may be implemented in another form, such as a soft key, on the display 106. In another embodiment, the key input devices may include a sensor module (not illustrated) that defines a sensing area (not illustrated) included in the screen display areas 110A and 110D.

In an embodiment, the connector hole 108 may accommodate a connector. The connector hole 108 may be disposed on the side surface 110C of the housing 110. For example, the connector hole 108 may be disposed on the side surface 110C to be adjacent to at least a portion of the audio module (e.g., the microphone hole 103 and the speaker hole 107). In another embodiment, the electronic device 101 may include the first connector hole 108 that may accommodate a connector (e.g., a USB connector) for transmitting/receiving electric power and/or data to and from an external device, and/or a second connector hole (not illustrated) that may accommodate a connector (e.g., an earphone jack) for transmitting/receiving an audio signal to and from the external device.

In an embodiment, the electronic device 101 may include a light emitting element (not illustrated). For example, the light emitting element (not illustrated) may be disposed on the first surface 110A of the housing 110. The light emitting element (not illustrated) may provide state information of the electronic device 101 in a form of light. In another embodiment, the light emitting element (not illustrated) may provide a light source that interworks with an operation of the first camera module 105. For example, the light emitting element (not illustrated) may include an LED, an IR LED, and/or a xenon lamp.

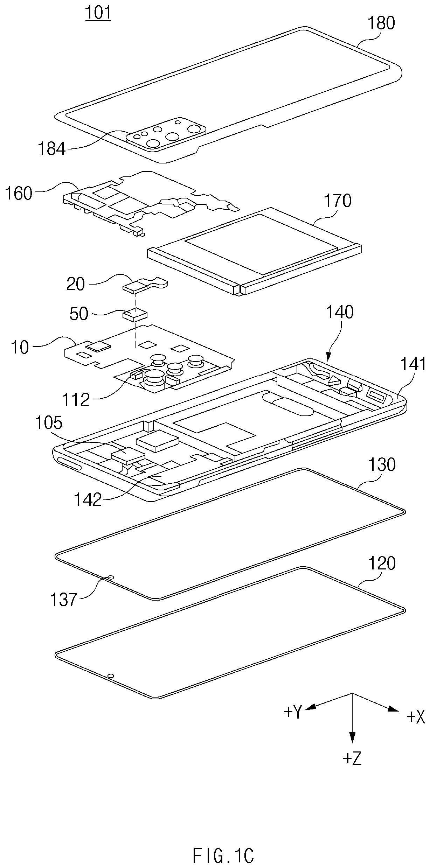

FIG. 1C is an exploded perspective view of the electronic device according to an embodiment. Referring to FIG. 1C, the electronic device 101 may include a front plate 120 (e.g., the front plate 102 of FIG. 1A), a display 130 (e.g., the display 106 of FIG. 1A), a bracket 140, a battery 170, a first board 10, a second board 20, a connector (or a connector structure) 50, a support member 160 (e.g., a rear case), and a rear plate 180 (e.g., the rear plate 111 of FIG. 1B).

In another embodiment, at least one (e.g., the support member 160) of the components of the electronic device 101 may be omitted, or another component may be additionally included. At least one of the components of the electronic device 101 may be the same as or similar to at least one of the components of the electronic device 101 of FIGS. 1A and 1B, and a repeated description thereof will be omitted below.

In an embodiment, at least some of the front plate 120, the rear plate 180, and the bracket 140 (e.g., a frame structure 141) may define a housing (e.g., the housing 110 of FIGS. 1A and 1B).

In an embodiment, the bracket 140 may include the frame structure 141 that defines a surface (e.g., a portion of the side surface 110C of FIG. 1A) of the electronic device 101, and a plate structure 142 that extends from the frame structure 141 to an inside of the electronic device 101.

The plate structure 142 may be located in the interior of the electronic device 101, be connected to the frame structure 141, or be integrally formed with the frame structure 141. The plate structure 142, for example, may be formed of a metallic material and/or a nonmetallic material (e.g., a polymer). The display 130 may be coupled to one surface of the plate structure 142, and the first board 10 may be coupled to a rear surface thereof. In an embodiment, the first board 10 may include a printed circuit board, in which nonconductive layers and conductive layers that form a circuit pattern of the board 10 are alternately laminated. In an embodiment, a processor, a memory, and/or an interface may be mounted on the first board 10 to be electrically connected to the circuit pattern of the first board 10. The processor, for example, may include one or more of a central processing unit, an application processor, a graphic processing unit, an image signal processor, a sensor hub processor, or a communication processor.

The memory, for example, may include a volatile memory or a nonvolatile memory.

The interface, for example, may include a high definition multimedia interface (HDMI), a universal serial bus (USB) interface, an SD card interface, and/or an audio interface. The interface, for example, may electrically and physically connect the electronic device 101 to an external device, and may include a USB connector, an SD card/MMC connector, or an audio connector.

In an embodiment, the second board 20 may be disposed on one surface (e.g., a surface that faces the -Z direction) of the first board 10, and may be connected to the first board 10. For example, the second board 20 may be connected to the first board 10 through the connector 50. In an embodiment, the second board 20 may include a printed circuit board, in which nonconductive layers and conductive layers that form a circuit pattern of the second board 20 are alternately laminated. In an embodiment, the second board 20 may include a structure of various printed circuit boards. For example, the second board 20 may include a rigid printed circuit board, a flexible printed circuit board, or a rigid-flexible printed circuit board.

In an embodiment, the battery 149 may supply electric power to at least one of the components of the electronic device 101. For example, the battery 149 may include a primary battery that cannot be recharged, a rechargeable secondary battery, or a fuel cell. In an embodiment, at least a portion of the battery 149 may be disposed on substantially the same plane as the first board 10. In an embodiment, the battery 149 may be disposed in the interior of the electronic device 101 to be integral therewith, or may be disposed to be detachable from the electronic device 101.

In an embodiment, the first camera module 105 may be disposed in the plate structure 142 of the bracket 140 such that the lens is exposed through a partial area of the front plate 120 (e.g., the front surface 110A of FIG. 1A) of the electronic device 101.

In an embodiment, the first camera module 105 may be disposed such that an optical axis of the lens is at least partially aligned with a hole or a recess 137 formed in the display 130. For example, an area, through which the lens is exposed, may be formed in the front plate 120. For example, at least a portion of the first camera module 105 may include a punch hole camera that is disposed in an interior of the hole or the recess 137 formed on a rear surface of the display 130.

In an embodiment, the second camera module 112 may be disposed in the first board 10 such that the lens is exposed through a camera area 184 of the rear plate 180 (e.g., the rear surface 110B of FIG. 1B) of the electronic device 101.

In an embodiment, the camera area 184 may be formed on a surface (e.g., the rear surface 110B of FIG. 1B) of the rear plate 180. In an embodiment, the camera area 184 may be formed to be at least partially transparent such that external light is input to the lens of the second camera module 112. In an embodiment, at least a portion of the camera area 184 may protrude from the surface of the rear plate 180 by a specific height. However, the disclosure is not necessarily limited thereto, and the camera area 184 may define substantially the same plane as the surface of the rear plate 180.

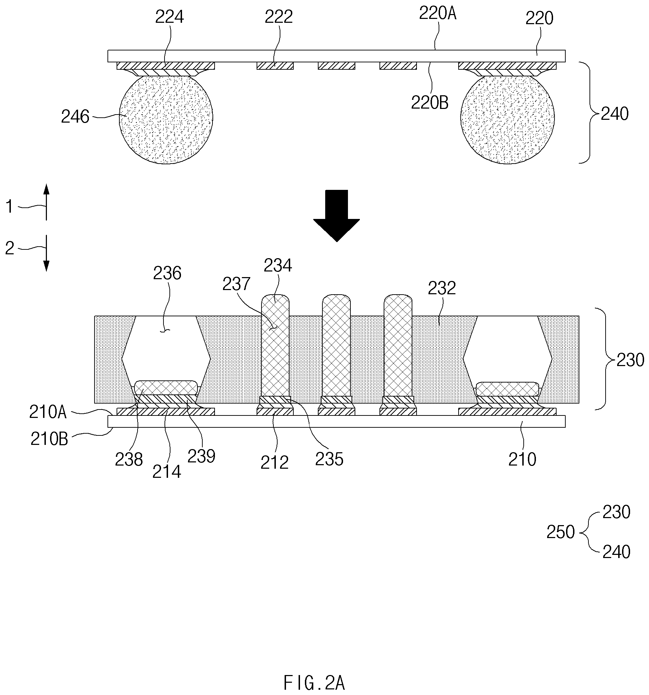

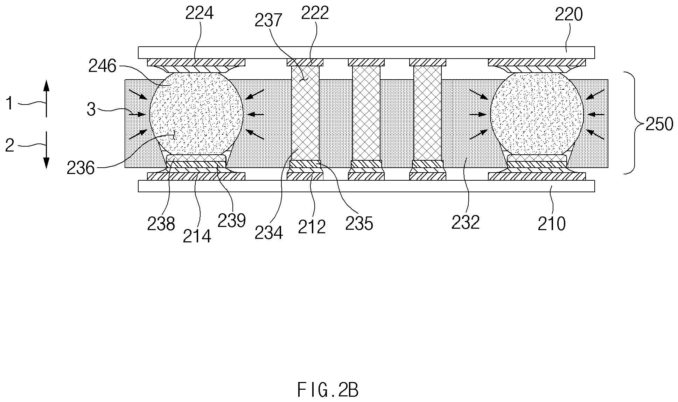

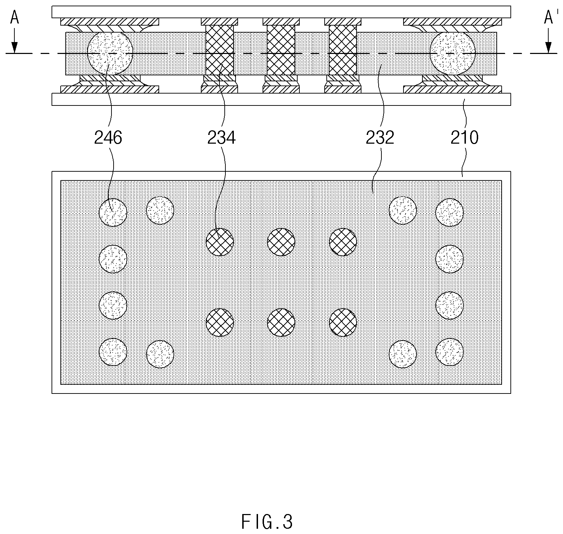

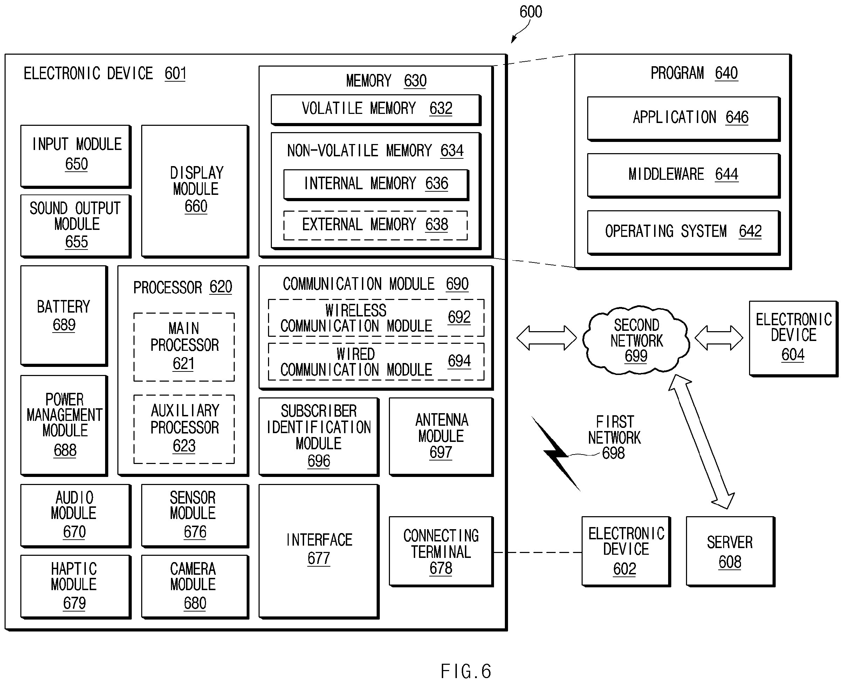

FIG. 2A is a view illustrating a connector structure of the electronic device according to an embodiment. FIG. 2B is a view illustrating a connector structure of the electronic device according to an embodiment. FIG. 3 is a view illustrating a connector structure of the electronic device according to an embodiment. Referring to FIGS. 2A, 2B, and 3, the electronic device (e.g., the electronic device 101 of FIG. 1A or the electronic device 601 of FIG. 6) according to an embodiment may include a first board 210, a second board 220, and a connector (or a connector structure) 250.

In an embodiment, the first board 210 (e.g., the first board 10 of FIG. 1C) may include a first surface 210A that faces a first direction 1, and a second surface 210B that faces a second direction 2 that is opposite to the first direction 1. The first direction 1 and the second direction 2 may be directions that are substantially perpendicular to the first board 210 and/or the second board 220 and are opposite to each other. In an embodiment, the first board 210 may include first conductive pads 212 and second conductive pads 214, which are formed on the first surface 210A. In an embodiment, the first conductive pads 212 and the second conductive pads 214 may include an electrically conductive metal (e.g., copper).

In an embodiment, the second board 220 (e.g., the second board 20 of FIG. 1C) may include a first surface 220A, and a second surface 220B that faces the first surface 220A and faces the first board 210. In an embodiment, the second board 220 may include third conductive pads 222 and fourth conductive pads 224, which are formed on the second surface 220B. In an embodiment, the third conductive pads 222 and the fourth conductive pads 224 may include an electrically conductive metal (e.g., copper). In an embodiment, the third conductive pads 222 of the second board 220 may at least partially overlap the first conductive pads 212 of the first board 210. For example, the third conductive pads 222 of the second board 220 may at least partially overlap the first conductive pads 212 of the first board 210 with respect to the first direction 1 or the second direction 2. In an embodiment, the fourth conductive pads 224 of the second board 220 may at least partially overlap the second conductive pads 214 of the first board 210. For example, the fourth conductive pads 224 of the second board 220 may at least partially overlap the second conductive pads 214 of the first board 210 with respect to the first direction 1 or the second direction 2.

In an embodiment, the connector 250 (e.g., the connector 50 of FIG. 1C) may be interposed between the first board 210 and the second board 220 to connect the first board 210 and the second board 220. In an embodiment, the connector 250 may include a first structure 230 and a second structure 240. In an embodiment, the first structure 230 may be disposed in the first board 210. For example, the first structure 230 may be disposed on the first surface 210A of the first board 210. In an embodiment, the second structure 240 may be disposed in the second board 220. For example, the second structure 240 may be disposed on the second surface 220B of the second board 220. In an embodiment, the first structure 230 and the second structure 240 may be coupled to each other to connect the first board 210 and the second board 220.

In an embodiment, the first structure 230 may include an insulating elastic member 232, a first connection member 234, and a first middle member 235.

In an embodiment, the insulating elastic member 232 may be disposed in the first surface 210A of the first board 210. The insulating elastic member 232 may be formed to be electrically insulating. In an embodiment, the insulating elastic member 232, for example, may include a synthetic rubber, such as silicon, polyimide, and/or urethane, but the disclosure is not limited thereto. In an embodiment, the insulating elastic member 232 may have a first hole 237, through which the first connection member 234 passes, and a second hole 236, through which a second connection member 246 of the second structure 240 is inserted.

In an embodiment, the insulating elastic member 232, for example, may be formed by applying a material (e.g., a liquid synthetic rubber) to a mold corresponding to a shape of the insulating elastic member 232. The first hole 237 and the second hole 236 of the insulating elastic member 232 may be formed during the molding process, or may be formed through a process, such as laser machining, after the molding process. In an embodiment, the insulating elastic member 232 may be attached to the first board 210 during the molding process, or may be attached to the first board 210 through a separate bonding member (not illustrated). However, the method for manufacturing the above-described insulating elastic member 232, and the method for disposing the insulating elastic member 232 on the first board 210 are not limited to the above-described examples, and various methods that may be applied by an ordinary person may be used.

In an embodiment, the first connection member 234 may include a conductive elastomer. For example, the first connection member 234 may include silicon rubber including conductive particles (e.g., metallic powder, such as a gold-nickel (Au-Ni) alloy, or metallic powder, such silver (Ag) or iron (Fe)), but the disclosure is not limited thereto.

In an embodiment, the first connection member 234 may extend from the first conductive pads 212 of the first board 210 toward the third conductive pads 222 of the second board 220 to pass through the insulating elastic member 232. For example, the first connection member 234 may extend in a direction (e.g., the first direction 1) that is substantially perpendicular to the first board 210 and/or the second board 220. For example, the first connection member 234 may extend straight from the first conductive pads 212 to the third conductive pads 222. In an embodiment, the first connection member 234 may be disposed at least partially in the first hole 237. For example, the first connection member 234 may partially protrude to an outside of the insulating elastic member 232 such that one end thereof is connected to the first conductive pads 212 and an opposite end thereof is pressed by the second board 220. In an embodiment, when the first structure 230 and the second structure 240 are coupled to each other, the first connection member 234 may be pressed by the second board 220 to electrically connect the first conductive pads 212 and the third conductive pads 222. The first connection member 234 may provide an elastic force to the second board 220, and through this, a reliability of electrical connection of the first board 210 and the second board 220 may be enhanced. In an embodiment, various components (not illustrated) (e.g., a processor 620, a communication module 690, or a memory 630 of FIG. 6) of the electronic device may be disposed in the first board 210 and/or the second board 220. In an embodiment, through the first connection member 234, electrical signals accompanied by the operations of the various components may be transmitted between the first board 210 and the second board 220.

In an embodiment, the first connection member 234 may be referenced as a first conduction member 234 in that it is pressed by the second board 220 to electrically connect the first conductive pads 212 and the third conductive pads 222.

In the comparative example, the first terminal 530 and the second terminal 540 of the connector structure 550 illustrated in FIG. 5 may have complex shapes to connect the first board 510 and the second board 520. Accordingly, because a volume in the connector structure 550, which is occupied by the first terminal 530 and the second terminal 540 is large, there is a restriction in disposition and arrangement of the pins of the connector structure 550 whereby an overall volume of the connector structure 550 also increases. In addition, signal transmission characteristics of the connector structure 550 may be degraded due to parts (e.g., stubs 534 and 544) that are not related to electrical connections accompanied by the first terminal 530 and the second terminal 540. Unlike this, because the first connection member 234 of the connector 250 according to an embodiment connects the first conductive pads 212 and the third conductive pads 222 vertically, design restrictions in disposition and arrangement of the connector 250 may be reduced. Through this, impedance matching of the connector 250 and a size of the connector 250 may be optimized. Furthermore, because unnecessary parts, such as the stubs 534 and 544 of the conventional technology, are not accompanied by the first connection member 234 that vertically connects the first conductive pads 212 and the third conductive pads 222, signal transmission characteristics may be enhanced and the connector 250 may be made small-sized.

In an embodiment, the insulating elastic member 232 and the first connection member 234 may absorb an impact that may be applied when the second structure 240 of the second board 220 is coupled to the first structure 230 of the first board 210, damage to the connector 250, which may be caused in the coupling process may be prevented.

In an embodiment, the first connection member 234, for example, may be formed by seating the insulating elastic member 232 in a mold and injecting a material (e.g., liquid silicon rubber containing conductive particles) into the first hole 237 of the insulating elastic member 232 or may be formed by applying a mold having a shape corresponding to the first connection member 234 separately from the insulating elastic member 232. However, the above-described method for manufacturing the first connection member 234 is not limited to the above-described example, and various methods that may be applied by an ordinary person may be used.

In an embodiment, the first connection member 234 may be bonded to the first conductive pads 212 of the first board 210 to be electrically connected to the first conductive pads 212. For example, the first connection member 234 may be bonded to the first conductive pads 212 through a soldering process. In this case, the first middle member 235 may be disposed between the first connection member 234 and the first conductive pads 212 such that the first connection member 234 is prevented from being damaged by heat accompanied in the soldering process. The first middle member 235, for example, may include a flexible printed circuit board, in which a conductive film (e.g., copper foil) or a conductive pattern that may electrically connects the first connection member 234 and the first conductive pads 212 is formed. As another example, the first connection member 234 may be bonded to the first conductive pads 212 in a scheme of being attached to the first conductive pads 212. In this case, the first middle member 235 may include a conductive tape for attaching the first connection member 234 to the first conductive pads 212. However, the above-described method for bonding the first connection member 234 and the first conductive pads 212 is not limited to the above-described example, and various methods that may be applied by an ordinary person may be used.

In an embodiment, the second structure 240 may include the second connection member 246. In an embodiment, the second connection member 246 may include a solder ball. In an embodiment, the second connection member 246 may be disposed on the third conductive pads 222 of the second board 220. In an embodiment, the second connection member 246 may be bonded to the third conductive pads 222 through a soldering process. In an embodiment, the second connection member 246 may not be bonded to the second conductive pads 214.

In an embodiment, the second structure 240 may be coupled to the first structure 230. In an embodiment, the second connection member 246 of the second structure 240 may be at least partially inserted into the second hole 236 of the insulating elastic member 232. In an embodiment, when the second connection member 246 is inserted into the insulating elastic member 232, the insulating elastic member 232 may at least partially surround the second connection member 246, and may provide an elastic force (e.g., a force in a third direction 2) that resists against deformation of the shape of the second hole 236 to the second connection member 246. To achieve this, the second hole 236 of the insulating elastic member 232 may have a shape that is substantially similar to that of the second connection member 246, and may have a volume that is smaller than that of the second connection member 246. In an embodiment, the elastic force provided by the insulating elastic member 232 may allow a state, in which the first connection member 234 is pressed by the second board 220, to be maintained. In an embodiment, the elastic force provided by the insulating elastic member 232 may allow a state, in which the first structure 230 and the second structure 240 are coupled to each other, to be maintained, and prevent the second structure 240 from being separated from the first structure 230. In an embodiment, according to the required elastic force, the numbers and/or sizes of the second connection member 246 and the second holes 236 may be changed.

In an embodiment, when the connector 250 is viewed from a top (e.g., when viewed in the second direction 2), the first connection member 234 may be located between the second connection members 246. In an embodiment, referring to FIG. 3, the second connection member 246 may at least partially surround a periphery of the first connection member 234.

In an embodiment, the first structure 230 of the connector 250 may further include a third connection member 238 and a second middle member 239. When the first structure 230 of the connector 250 does not include the third connection member 238 and the second middle member 239, the second conductive pads 214 of the first board 210 may be omitted, and the second hole 236 of the insulating elastic member 232 may be replaced by an opening (or a groove), one side (a part that faces the first board 210) of which is closed.

In an embodiment, the third connection member 238 may be disposed between the second connection member 246 and the second conductive pads 214, in the second hole 236 of the insulating elastic member 232. In an embodiment, a height (e.g., a length along the first direction 1 or the second direction 2) of the third connection member 238 may be smaller than that of the second connection member 246.

In an embodiment, the third connection member 238 may include a conductive elastic material (e.g., a synthetic rubber including metallic powder). In an embodiment, the third connection member 238 may be bonded to the second conductive pads 214 to be electrically connected thereto. For example, the third connection member 238 may be bonded to the second conductive pads 214 by using the second middle member 239 similarly to the aspect that the above-described first connection member 234 is coupled to the first conductive pads 212 by using the first middle member 235.

In an embodiment, when the first structure 230 and the second structure 240 are coupled to each other, the third connection member 238 may contact the second connection member 246 to be pressed. In this case, through the second connection member 246 and the third connection member 238, the second conductive pads 214 and the fourth conductive pads 224 may be electrically connected to each other. In an embodiment, the third connection member 238 may be referenced as the second conductive elastic member 238 in that it is pressed by the second connection member 246 to electrically connect the second conductive pads 214 and the fourth conductive pads 224.

In an embodiment, the second conductive pads 214 of the first board 210 may be electrically connected to a ground part provided in the first board 210. In this case, as illustrated in FIG. 3, the second connection member 246 may surround a periphery of the first connection member 234 or the first connection member 234 may be located between the second connection members 246 whereby transmission characteristics of electrical signals transmitted through the first connection member 234 may be enhanced. For example, the first connection member 234 may be shielded by the second connection member 246, and thus, characteristics of signals transmitted through the first connection member 234 may be enhanced. In another embodiment, at least one of the second conductive pads 214 may be electrically connected to contact points of other component (not illustrated) (e.g., the processor 620, the communication module 690, or the memory 630 of FIG. 6) disposed in the first board 210. In this case, by using the second connection member 246 and the third connection member 238 connected to the at least one of the second conductive pads 214, electrical signals that are necessary for operation of the other components may be transmitted.

In the description made with reference to FIGS. 2A, 2B, and 3, some components have been described to be plural (e.g., the first conductive pads 212) and some components have been described to be singular (e.g., the first connection member 234), but this is simply for convenience of description and the component does not necessarily need to be singular or plural.

An electronic device (e.g., the electronic device 101 of FIG. 1A) according to various embodiments may include a first board (e.g., the first board 210 of FIG. 2A) including first conductive pads (e.g., the first conductive pads 212 of FIG. 2A) formed on one surface (e.g., the first surface 210A of FIG. 2A) thereof, a second board (e.g., the second board 220 of FIG. 2A) including second conductive pads (e.g., the third conductive pads 222 of FIG. 2A) and third conductive pads (e.g., the fourth conductive pads 224 of FIG. 2A) facing the one surface of the first board, and a connector (e.g., the connector 250 of FIG. 2B) interposed between the first board and the second board and connecting the first board and the second board, the connector may include an insulating elastic member (e.g., the insulating elastic member 232 of FIG. 2B) disposed on the one surface of the first board, first connection members (e.g., the first connection member of FIG. 2B) passing through the insulating elastic member and electrically connecting the first conductive pads and the second conductive pads, and second connection members (e.g., the second connection member 246 of FIG. 2B) disposed between the third conductive pads of the second board, and the second connection members may be at least partially inserted into the insulating elastic member to be provided with an elastic force by the insulating elastic member.

In an embodiment, the second connection members may be bonded to the third conductive pads.

In an embodiment, the first board may include fourth conductive pads (e.g., the second conductive pads 214 of FIG. 2B) formed on the one surface, the fourth conductive pads may overlap the third conductive pads of the second board, respectively and the second connection members may not be bonded to the fourth conductive pads.

In an embodiment, the connector includes third connection members (e.g., the third connection member 238 of FIG. 2B) disposed between the second connection members and the fourth connection pads and contacting the second connection members, and the third connection members may be electrically connected to the fourth conductive pads.

In an embodiment, the first connection members and the third connection members may be an elastic body including metal powder.

In an embodiment, the third connection members may have heights that are smaller than those of the first connection members.

In an embodiment, the electronic device may include electronic parts disposed in the first board, and at least one of the fourth conductive pads may be electrically connected to the electronic parts.

In an embodiment, the first board may include a ground part, and the ground part may be electrically connected to the fourth conductive pads.

In an embodiment, the first connection members may be located between the second connection members when viewed from a top of the first board.

In an embodiment, the second connection members may include solder balls.

In an embodiment, the first conductive pads may overlap the second conductive pads, respectively.

In an embodiment, the first connection members may extend straight from the first conductive pads to the second conductive pads.

In an embodiment, the insulating elastic member may include silicon rubber.

In an embodiment, one end of the first connection member may be bonded to the first conductive pads, and an opposite end of the first connection member may protrude to an outside of the insulating elastic member to be pressed by the second board.

In an embodiment, the second board may include a rigid printed circuit board, a flexible printed circuit board, or a rigid-flexible printed circuit board.

In an embodiment, the insulating elastic member may have a through-hole (e.g., the second hole 236 of FIG. 2B) or an opening being opened in a direction facing the second board and being closed in a direction facing the first board, and the second connection members may be at least partially inserted into the through-hole or the opening of the insulating elastic member.

A connector (e.g., the connector 250 of FIG. 2B) interposed between a first board (e.g., the first board 210 of FIG. 2B) and a second board (e.g., the second board 220 of FIG. 2B) and configured to connect the first board and the second board according to various embodiments include an insulating elastic member (e.g., the insulating elastic member 232 of FIG. 2B) disposed on a first surface (e.g., the first surface 210A of FIG. 2A) of the first board, first conductive elastic members (e.g., the first connection member 234 of FIG. 2B) electrically connecting first conductive pads (e.g., the first conductive pads 212 of FIG. 2B) passing through the insulating elastic member and formed on the first surface of the first board, and second conductive pads (e.g., the third conductive pads 222 of FIG. 2B) formed in the second board and facing the first board, and solder balls (e.g., the second connection member 246 of FIG. 2B) formed in the second board and bonded to third conductive pads (e.g., the fourth conductive pads 224 of FIG. 2B) facing the first board, and the solder balls may be at least partially inserted into the insulating elastic member to be provided with an elastic force by the insulating elastic member.

In an embodiment, ends of the first conductive elastic members may be bonded to the first conductive pads, and opposite ends of the first conductive elastic members may be pressed by the second board.

In an embodiment, the connector may include fourth conductive pads (e.g., the second conductive pads 214 of FIG. 2B) formed on the first surface of the first board and overlapping the third conductive pads, and second conductive elastic members (e.g., the third connection member 238 of FIG. 2B) disposed between the solder balls and having heights that are smaller than those of the first conductive elastic member, and the second conductive elastic members may contact the solder balls, respectively, and may be bonded to the fourth conductive pads.

In an embodiment, the first conductive pads may be electrically connected to electronic parts disposed in the first board, and the fourth conductive pads may be electrically connected to a ground part of the first board.

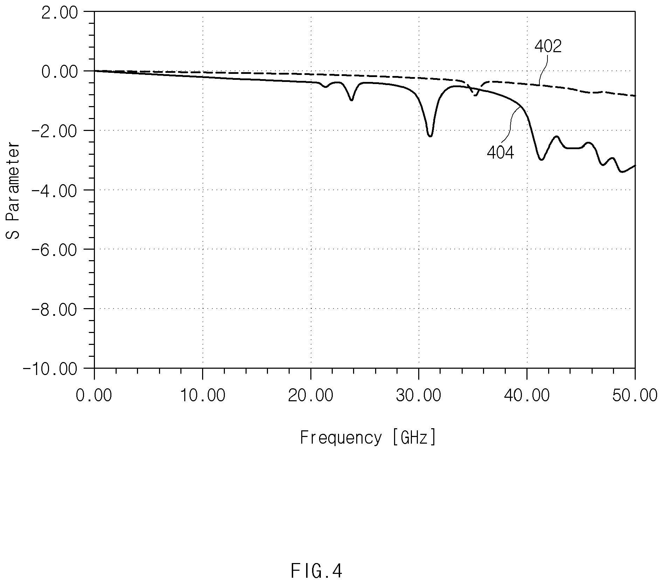

FIG. 4 is a graph depicting an S-parameter of a connector structure according to an embodiment, and an S-parameter of a connector structure according to a comparative example.

Reference numeral 402 of FIG. 4 may be an S-parameter of the first connection member (e.g., the first connection member 234 of FIG. 2A) of the connector (e.g., the connector 250 of FIG. 2A) according to an embodiment.

Reference numeral 404 of FIG. 4 may be S-parameters of a first terminal (e.g., the first terminal 530 of FIG. 5) and a second terminal (e.g., the second terminal 540 of FIG. 5) of a connector structure (e.g., the connector structure 550 of FIG. 5) of a conventional technology.

Referring to FIG. 4, the connector according to an embodiment may have signal transmission characteristics that are enhanced as compared with those of the connector structure according to the comparative example. Signal losses of the connector according to an embodiment may smaller than those of the connector structure according to the comparative example. The connector according to an embodiment may generate a resonance of signals that is lower than that of the connector structure according to the comparative example.

FIG. 6 is a block diagram illustrating an electronic device 601 in a network environment 600 according to various embodiments.

Referring to FIG. 6, the electronic device 601 in the network environment 600 may communicate with an electronic device 602 via a first network 698 (e.g., a short-range wireless communication network), or at least one of an electronic device 604 or a server 608 via a second network 699 (e.g., a long-range wireless communication network). According to an embodiment, the electronic device 601 may communicate with the electronic device 604 via the server 608. According to an embodiment, the electronic device 601 may include a processor 620, a memory 630, an input module 650, a sound output module 655, a display module 660, an audio module 670, a sensor module 676, an interface 677, a connecting terminal 678, a haptic module 679, a camera module 680, a power management module 688, a battery 689, a communication module 690, a subscriber identification module (SIM) 696, or an antenna module 697. In some embodiments, at least one (e.g., the connecting terminal 678) of the components may be omitted from the electronic device 601, or one or more other components may be added in the electronic device 601. In some embodiments, some of the components may be implemented as single integrated circuitry. For example, some (e.g., the sensor module 676, the camera module 680, or the antenna module 697) of the components may be implemented as embedded in the display module 660 (e.g., a display).

The processor 620 may execute, for example, software (e.g., a program 640) to control at least one other component (e.g., a hardware or software component) of the electronic device 601 coupled with the processor 620, and may perform various data processing or computation. According to one embodiment, as at least part of the data processing or computation, the processor 620 may load a command or data received from another component (e.g., the sensor module 676 or the communication module 690) in a volatile memory 632, process the command or the data stored in the volatile memory 632, and store resulting data in a non-volatile memory 634. According to an embodiment, the processor 620 may include a main processor 621 (e.g., a central processing unit (CPU) or an application processor (AP)), and an auxiliary processor 623 (e.g., a graphics processing unit (GPU), a neural processing unit (NPU), an image signal processor (ISP), a sensor hub processor, or a communication processor (CP)) that is operable independently from, or in conjunction with, the main processor 621. When the electronic device 601 includes the main processor 621 and the auxiliary processor, the auxiliary processor 623 may be adapted to consume less power than the main processor 621, or to be specific to a specified function. The auxiliary processor 623 may be implemented as separate from, or as part of the main processor 621.

The auxiliary processor 623 may control at least some of functions or states related to at least one component (e.g., the display module 660, the sensor module 676, or the communication module 690) among the components of the electronic device 601, instead of the main processor 621 while the main processor 621 is in an inactive (e.g., sleep) state, or together with the main processor 621 while the main processor 621 is in an active state (e.g., executing an application). According to an embodiment, the auxiliary processor 623 (e.g., an image signal processor or a communication processor) may be implemented as part of another component (e.g., the camera module 680 or the communication module 690) functionally related to the auxiliary processor 623. According to an embodiment, the auxiliary processor 623 (e.g., a neural network processing device) may include a hardware structure specified for processing an artificial intelligence (AI) model. The AI model may be generated through machine learning. The learning may be performed by the electronic device 601 performing the AI model, and may be performed through an additional server (e.g., the server 608). A learning algorithm may include, for example, a supervised learning algorithm, an unsupervised learning algorithm, a semi-supervised learning algorithm, or a reinforcement learning algorithm, but the disclosure is not limited thereto. The AI model may include a plurality of artificial neural network (ANN) layers. The ANN may include a deep neural network (DNN), a convolutional neural network (CNN), a recurrent neural network (RNN), a restricted boltzman machine (RBM), a deep belief network (DBN), a bidirectional recurrent deep neural network (BRDNN), a deep Q-networks or the combination of the above networks, but the disclosure is not limited thereto. The AI model may additionally or alternatively include a software structure, in addition to a hardware structure.

The memory 630 may store various data used by at least one component (e.g., the processor 620 or the sensor module 676) of the electronic device 601. The various data may include, for example, software (e.g., the program 640) and input data or output data for a command related thererto. The memory 630 may include the volatile memory 632 or the non-volatile memory 634.

The program 640 may be stored in the memory 630 as software, and may include, for example, an operating system (OS) 642, middleware 644, or an application 646.

The input module 650 may receive a command or data to be used by other component (e.g., the processor 620) of the electronic device 601, from the outside (e.g., a user) of the electronic device 601. The input module 650 may include, for example, a microphone, a mouse, a keyboard, a key (e.g., a button), or a digital pen (e.g., a stylus pen).

The sound output module 655 may output sound signals to the outside of the electronic device 601. The sound output module 655 may include, for example, a speaker or a receiver. The speaker may be used for general purposes, such as playing multimedia or playing record, and the receiver may be used for an incoming calls. According to an embodiment, the receiver may be implemented as separate from, or as part of the speaker.

The display module 660 may visually provide information to the outside (e.g., a user) of the electronic device 601. The display module 660 may include, for example, a display, a hologram device, or a projector and control circuitry to control a corresponding one of the display, hologram device, and projector. According to an embodiment, the display module 660 may include touch sensor adapted to detect a touch, or a pressure sensor adapted to measure the intensity of force incurred by the touch.

The audio module 670 may convert a sound into an electrical signal and vice versa. According to an embodiment, the audio module 670 may obtain the sound via the input module 650, or output the sound via the sound output module 655 or an external electronic device (e.g., the electronic device 602) (e.g., speaker of headphone) directly (e.g., wiredly) or wirelessly coupled with the electronic device 601.

The sensor module 676 may detect an operational state (e.g., power or temperature) of the electronic device 601 or an environmental state (e.g., a state of a user) external to the electronic device 601, and then generate an electrical signal or data value corresponding to the detected state. According to an embodiment, the sensor module 676 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 677 may support one or more specified protocols to be used for the electronic device 601 to be coupled with the external electronic device (e.g., the electronic device 602) directly (e.g., wiredly) or wirelessly. According to an embodiment, the interface 677 may include, for example, a high definition multimedia interface (HDMI), a universal serial bus (USB) interface, a secure digital (SD) card interface, or an audio interface.

A connecting terminal 678 may include a connector via which the electronic device 601 may be physically connected with the external electronic device (e.g., the electronic device 602). According to an embodiment, the connecting terminal 678 may include, for example, a HDMI connector, a USB connector, a SD card connector, or an audio connector (e.g., a headphone connector).

The haptic module 679 may convert an electrical signal into a mechanical stimulus (e.g., a vibration or a movement) or electrical stimulus which may be recognized by a user via his tactile sensation or kinesthetic sensation. According to an embodiment, the haptic module 679 may include, for example, a motor, a piezoelectric element, or an electric stimulator.

The camera module 680 may capture a still image or moving images. According to an embodiment, the camera module 680 may include one or more lenses, image sensors, image signal processors, or flashes.

The power management module 688 may manage power supplied to the electronic device 601. According to one embodiment, the power management module 688 may be implemented as at least part of, for example, a power management integrated circuit (PMIC).

The battery 689 may supply power to at least one component of the electronic device 601. According to an embodiment, the battery 689 may include, for example, a primary cell which is not rechargeable, a secondary cell which is rechargeable, or a fuel cell.

The communication module 690 may support establishing a direct (e.g., wired) communication channel or a wireless communication channel between the electronic device 601 and the external electronic device (e.g., the electronic device 602, the electronic device 604, or the server 608) and performing communication via the established communication channel. The communication module 690 may include one or more communication processors that are operable independently from the processor 620 (e.g., the application processor (AP)) and supports a direct (e.g., wired) communication or a wireless communication. According to an embodiment, the communication module 690 may include a wireless communication module 692 (e.g., a cellular communication module, a short-range wireless communication module, or a global navigation satellite system (GNSS) communication module) or a wired communication module 694 (e.g., a local area network (LAN) communication module or a power line communication (PLC) module). The corresponding communication module from among the communication modules may communicate with the external electronic device via the first network 698 (e.g., a short-range communication network, such as Bluetooth^{™}, wireless-fidelity (WiFi) direct, or infrared data association (IrDA)) or the second network 699 (e.g., a long-range communication network, such as a legacy cellular network, 5G network, next generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 692 may identify or authenticate the electronic device 601 in a communication network, such as the first network 698 or the second network 699, using subscriber information (e.g., international mobile subscriber identity (IMSI)) stored in the subscriber identification module 696.

The wireless communication module 692 may support a 5G network and a next-generation communication technology, for example, a new radio (NR) access technology after a 4G network. The NR access technology may support high-speed transmission for high capacity data (enhanced mobile broadband; eMBB), terminal power minimizing and multiple terminal access (massive machine type communication; mMTC), or ultra-reliable and low-latency communications (URLLC). The wireless communication module 692 may support a high-frequency band (e.g., mmWave band) to achieve, for example, a higher data rate. The wireless communication module 692 may support various technologies, for example, beamforming, massive multiple-input and multiple-output (MIMO), Full-dimensional MIMO, an array antenna, analog beamforming, or a large-scale antenna, to secure performance in high frequency bands. The wireless communication module 692 may support various requirements defined in the electronic device 601, the external electronic device (e.g., the electronic device 604) or the network system (e.g., the second network 699). According to one embodiment, the wireless communication module 692 may support a peak data rate (e.g., 20Gbps or more) for eMBB realization, loss coverage (e.g., 164 dB or less) for mMTC realization, or U-plane latency (e.g., 0.5 ms or less, or the round trip of 1 ms or less in each of a downlink (DL) and an uplink (UL)) for URLCC realization.

The antenna module 697 may transmit or receive a signal or power to or from the outside (e.g., the external electronic device) of the electronic device 601. According to an embodiment, the antenna module 697 may include an antenna including a radiating element composed of a conductive material or a conductive pattern formed in or on a substrate (e.g., PCB). According to an embodiment, the antenna module 697 may include a plurality of antennas (e.g., an array antenna). In such a case, at least one antenna appropriate for a communication scheme used in the communication network, such as the first network 698 or the second network 699, may be selected, for example, by the communication module 690 from the plurality of antennas. The signal or the power may then be transmitted or received between the communication module 690 and the external electronic device via the selected at least one antenna. According to an embodiment, another component (e.g., a radio frequency integrated circuit (RFIC)) other than the radiating element may be additionally formed as part of the antenna module 697.

According to various embodiments, the antenna module 697 may form an mmWave antenna module. According to an embodiment, the mmWave antenna module may include a printed circuit board, an RFIC disposed on a first surface (e.g., a bottom surface) of the printed circuit board, or disposed adjacent to the first surface to support the specific high frequency band (e.g., mmWave band), and a plurality of antennas (e.g., an array antenna) disposed on a second surface (e.g., a top surface or a side surface) of the printed circuit board or disposed adjacent to the second surface to transmit or receive a signal having the specified high frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 601 and the external electronic device 604 via the server 608 coupled with the second network 699. Each of the external electronic devices 602 or 604 may be a device of a same type as, or a different type, from the electronic device 601. According to an embodiment, all or some of operations to be executed at the electronic device 601 may be executed at one or more of the external electronic devices 602, 604, or 608. For example, when the electronic device 601 should perform a function or a service automatically, or in response to a request from a user or another device, the electronic device 601, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 601. The electronic device 601 may provide the outcome, with or without further processing of the outcome, as at least part of a reply to the request. To that end, a cloud computing, distributed computing, mobile edge computing (MEC), or client-server computing technology may be used, for example. The electronic device 601 may provide an ultra-latency service by using, for example, distributed computing or mobile edge computing. According to various embodiments, the external electronic device 604 may include the Internet of things (IoT). The server 608 may be an artificial server using machine learning and/or a neural network. According to an embodiment, the external electronic device 604 or the server 608 may be included in the second network 699. The electronic device 601 may be applied to an artificial intelligence service (e.g., a smart home, a smart city, a smart car, or healthcare service) based on the 5G communication technology and the IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 640) including one or more instructions that are stored in a storage medium (e.g., internal memory 636 or external memory 638) that is readable by a machine (e.g., the electronic device 601). For example, a processor (e.g., the processor 620) of the machine (e.g., the electronic device 601) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities and some of multiple entities may be separately disposed on the other components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device comprising:
a first board including first conductive pads formed on one surface thereof;
a second board including second conductive pads and third conductive pads facing the one surface of the first board; and
a connector interposed between the first board and the second board and connecting the first board and the second board,
wherein the connector includes:
an insulating elastic member disposed on the one surface of the first board;
first connection members passing through the insulating elastic member and electrically connecting the first conductive pads and the second conductive pads; and
second connection members disposed between the third conductive pads of the second board, and
wherein the second connection members are at least partially inserted into the insulating elastic member to be provided with an elastic force by the insulating elastic member.

2. The electronic device of claim 1, wherein the second connection members are bonded to the third conductive pads.

3. The electronic device of claim 2, wherein the first board includes fourth conductive pads formed on the one surface,
wherein the fourth conductive pads overlap the third conductive pads of the second board, respectively, and
wherein the second connection members are not bonded to the fourth conductive pads.

4. The electronic device of claim 3, wherein the connector includes third connection members disposed between the second connection members and the fourth connection pads and contacting the second connection members, and
wherein the third connection members are electrically connected to the fourth conductive pads.

5. The electronic device of claim 4, wherein the first connection members and the third connection members include metal powder.

6. The electronic device of claim 4, wherein the third connection members have heights that are smaller than those of the first connection members.

7. The electronic device of claim 4, comprising:
electronic parts disposed in the first board,
wherein at least one of the fourth conductive pads are electrically connected to the electronic parts.

8. The electronic device of claim 4, wherein the first board includes a ground part, and
wherein the ground part is electrically connected to the fourth conductive pads.

9. The electronic device of claim 8, wherein the first connection members are located between the second connection members when viewed from a top of the first board.

10. The electronic device of claim 1, wherein the second connection members include solder balls.

11. The electronic device of claim 1, wherein the first conductive pads overlap the second conductive pads, respectively, and
wherein the first connection members extend straight from the first conductive pads to the second conductive pads.

12. The electronic device of claim 1, wherein the insulating elastic member includes silicon rubber.

13. The electronic device of claim 1, wherein one end of the first connection member is bonded to the first conductive pads, and an opposite end of the first connection member protrudes to an outside of the insulating elastic member to be pressed by the second board.

14. The electronic device of claim 1, wherein the second board includes a rigid printed circuit board, a flexible printed circuit board, or a rigid-flexible printed circuit board.

15. The electronic device of claim 1, wherein the insulating elastic member has a through-hole or an opening being opened in a direction facing the second board and being closed in a direction facing the first board, and
wherein the second connection members are at least partially inserted into the through-hole or the opening of the insulating elastic member.
